# EUROPEAN PATENT SPECIFICATION

(11) **EP 1 876 419 B1**
(45) Date of publication and mention of the grant of the patent: **15.10.2008**
(21) Application number: 06013763.5
(22) Date of filing: 03.07.2006
(51) Int. Cl.: G01C 21/20

(54) **Watertight navigation device**
Wasserdichte Navigationsvorrichtung
Dispositif de navigation étanche

(43) Date of publication of application: 09.01.2008
(73) Proprietor: Continental Automotive GmbH, 30165 Hannover (DE)
(72) Inventor: Tan, Kay Soon, 530020 Singapore (SG)

(56) References cited:
- US-A1- 2003 095 374
- US-A1- 2006 012 559
- US-A1- 2006 022 958
- US-B1- 6 751 552
- US-B1- 6 844 845
- US-B1- 6 956 180

## Description

The invention relates to a navigation device comprising a housing, a display and a panel which covers the display towards the outside of the housing.

US 2006/0012559 A1 discloses a speaker apparatus for a mobile communications terminal. The speaker apparatus includes a display window which acts as a speaker by using the display window as a vibration plate. As a result, sound in lower frequency range can be reproduced. In addition through the use of filters, frequency characteristics can be further enhanced.

US 6 751 552 B1 discloses a waterproof navigation device without a speaker.

US 2006/0022958 A1 discloses a touch panel input device having a function for providing vibrations. The touch panel input device includes a touch panel receiving an operation on an operation item on a display panel, a vibration controlling unit vibrating the touch panel, an operation detector detecting an operation on the touch panel and an operation mode controlling unit. The operation mode controlling unit sets an operation mode of the touch panel to an input operation for vibrating the touch panel upon detecting a touch on the touch panel, or either a speaker mode for vibrating the touch panel to produce sounds or a microphone mode for allowing a voice input by transmitting vibrations generated to the touch panel when the operator speaks to the touch panel. The operation mode controlling unit changes the operation mode to the input operation mode when the operation is set to the speaker mode or the microphone mode upon detecting an operation on the touch panel.

It is an object of the invention to create a watertight navigation device in a simple way.

The object is achieved by the features of the independent claim 1. Advantageous embodiments of the invention are explained in the sub-claims.

The invention is distinguished by a watertight navigation device. The watertight navigation device comprises a watertight housing and a transparent watertight panel. The watertight housing takes in a display. The transparent watertight panel covers the display towards the outside of the watertight housing. A transparent watertight panel works as a panel type speaker. The watertight housing and the transparent watertight panel are sealingly coupled with each other.

This enables not to arrange any common speaker which needs holes in the watertight housing and which needs much space in the navigation device. This contributes to make the watertight navigation device watertight in a simple way. Further, this enables to create a compact watertight navigation device.

In an advantageous embodiment of the watertight navigation device, the transparent panel works as a touch panel. This enables to input data into the watertight navigation device without any buttons. This contributes to make the navigation device watertight in a simple way.

In a further advantageous embodiment of the watertight navigation device, the watertight navigation device comprises a first gasket which is formed and arranged between the watertight housing and the transparent watertight panel. This contributes to make the watertight navigation device watertight in an easy way.

In a further advantageous embodiment of the watertight navigation device, the watertight navigation device comprises at least one button which is watertightly arranged in an opening of the watertight housing. This enables an input into the navigation device outside of the watertight panel. For example, the button is a power on/off button.

In a further advantageous embodiment of the watertight navigation device, the watertight navigation device comprises a second gasket which is formed and arranged between the watertight housing and the watertight button for sealing up the navigation device. This contributes to make the navigation device watertight in an easy way.

In a further advantageous embodiment of the watertight navigation device, the watertight housing comprises at least one compartment with a compartment cover. This may enable a change of a battery and/or of a GPS antenna and/or, in case, this may enable a service of the navigation device in a simple way.

In a further advantageous embodiment of the watertight navigation device, a third gasket is formed and arranged between the watertight housing and/or the compartment cover. This contributes to make the navigation watertight in an easy way.

The invention is explained in the following with the help of schematic drawings.

These are as follows:
- figure 1: a front view of a watertight navigation device,
- figure 2: a back view of the watertight navigation device,
- figure 3: a side view of the watertight navigation device.

Elements with the same design or function that appear in the different illustrations are identified by the same reference characters.

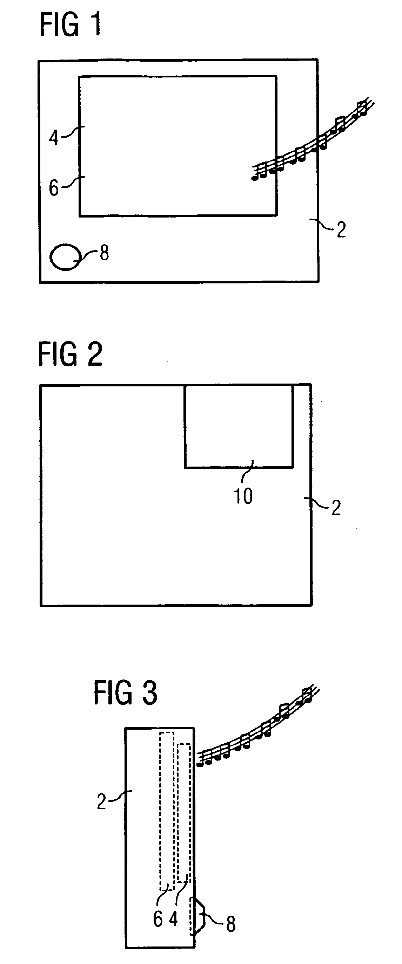

A watertight navigation device (figure 1) comprises a watertight housing 2, a transparent watertight panel 4, and a display 6. For example, the display 6 is an LCD display.

The transparent watertight panel 4 covers the display 6 towards the outside of the watertight navigation device (figure 3). Preferably, a first gasket is arranged between the watertight housing 2 and the watertight transparent panel 4 for sealing up the watertight navigation device against water. The first gasket and, in case, further gaskets may comprise a thermoplastic rubber.

The watertight navigation device may comprise a button 8. Preferably, the button 8 is watertight and an on/off button 8 to shut on/off the watertight navigation device. Preferably, a second gasket is arranged between the button 8 and the watertight housing 2 for sealing up the watertight navigation device against water. Alternatively, the button 8 may be covered with a lamination for sealing up the recess for the button 8 in the watertight housing 2. The lamination may comprise rubber.

The transparent watertight panel 4 may be used as a panel type speaker. Therefore, the watertight navigation device comprises means for vibrating the watertight transparent panel 4 in such a way that a sound is created by the vibrating watertight transparent panel 4. This enables not to arrange a common speaker. This enables to leave out holes in the watertight housing 2 which would be necessary if the navigation device would have the common speaker. So, there are no holes in the watertight housing 2 which would have to be sealed against the environment of the watertight navigation device. This contributes to make the watertight navigation device watertight while having a simple design of the watertight navigation device.

Preferably, the watertight transparent panel 4 also works as a touch panel. This enables to reduce the amount of buttons 8 to only one button 8 while being able to use the full functionality of the watertight navigation device. The fewer buttons 8 there are the fewer holes have to be drilled in the watertight housing 2 and the fewer gaskets have to be arranged. This contributes to make the watertight navigation device watertight in an easy way and reduces the amount of work and costs for producing the watertight navigation device.

Further, the watertight navigation device preferably comprises a compartment with a compartment cover 10 (figure 2). The compartment may be used for taking in at least one battery, a GPS-antenna or any other position recognition system. Further, the compartment may enable a simple service of the watertight navigation device. Preferably, there is arranged a third gasket between the watertight housing 2 and the compartment cover for sealing up the watertight navigation device.

Preferably, the watertight housing 2, the watertight transparent panel 4, and the button 8 are the only parts of the watertight navigation device which are exposed to the environmental conditions and which, in case, come in contact with, for example water.

The invention is not restricted by the explained embodiments. For example, the watertight navigation device may comprise one or more further compartments and/or one or more further buttons 8 (Figure 3).

## Claims

1. Watertight navigation device comprising a watertight housing (2) which takes in a display (6) and comprising a transparent watertight panel (4) which covers the display (6) towards the outside of the watertight housing (2), **characterized in that** the panel works as a panel-type speaker, the watertight housing and the transparent watertight panel (4) being sealingly coupled with each other.

2. Watertight navigation device in accordance with claim 1 wherein the transparent watertight panel (4) works as a touch-panel.

3. Watertight navigation device in accordance with one of the preceding claims comprising a first gasket which is formed and arranged between the watertight housing (2) and the transparent watertight panel (4)

4. Watertight navigation device in accordance with one of the preceding claims comprising at least one button (8) which is watertightly arranged in an opening of the watertight housing (2).

5. Watertight navigation device in accordance with claim 4 comprising a second gasket which is formed and arranged between the watertight housing (2) and the watertight button (8) for sealing up the navigation device.

6. Watertight navigation device in accordance with one of the preceding claims with the watertight housing (2) comprising at least one compartment with a compartment cover (10).

7. Watertight navigation device in accordance with claim 6 comprising a third gasket which is formed and arranged between the watertight housing (2) and/or the compartment cover (10).

## Patentansprüche

1. Wasserdichte Navigationsvorrichtung mit einem wasserdichten Gehäuse (2), in dem eine Anzeige (6) aufgenommen ist und das ein transparentes wasserdichtes Feld (4) umfasst, das die Anzeige (6) zur Außenseite des wasserdichten Gehäuses (2) hin abdeckt, **dadurch gekennzeichnet, dass** das Feld als Feld-Lautsprecher wirkt, wobei das wasserdichte Gehäuse und das transparente wasserdichte Feld (4) dichtend aneinander gekoppelt sind.

2. Wasserdichte Navigationsvorrichtung nach Anspruch 1, wobei das transparente wasserdichte Feld (4) als Berührungsfeld wirkt.

3. Wasserdichte Navigationsvorrichtung nach einem der vorhergehenden Ansprüche mit einer ersten Dichtung, die zwischen dem wasserdichten Gehäuse (2) und dem transparenten wasserdichten Feld (4) ausgebildet und angeordnet ist.

4. Wasserdichte Navigationsvorrichtung nach einem der vorhergehenden Ansprüche mit mindestens einem Knopf (8), der wasserdicht in einer Öffnung des wasserdichten Gehäuses (2) angeordnet ist.

5. Wasserdichte Navigationsvorrichtung nach Anspruch 4, mit einer zweiten Dichtung, die zwischen dem wasserdichten Gehäuse (2) und dem wasserdichten Knopf (8) ausgebildet und angeordnet ist, um die Navigationsvorrichtung abzudichten.

6. Wasserdichte Navigationsvorrichtung nach einem der vorhergehenden Ansprüche, wobei das wasserdichte Gehäuse (2) mindestens ein Fach mit einer Fachabdeckung (10) hat.

7. Wasserdichte Navigationsvorrichtung nach Anspruch 6, mit einer dritten Dichtung, die zwischen dem wasserdichten Gehäuse (2) und/oder der Fachabdeckung (10) ausgebildet und angeordnet ist.

## Revendications

1. Dispositif de navigation étanche à l'eau comprenant un logement étanche à l'eau (2) qui comprend un affichage (6) et comprenant un panneau étanche à l'eau transparent (4) qui couvre l'affichage (6) vers l'extérieur du logement étanche à l'eau (2), **caractérisé en ce que** le panneau fonctionne en tant que haut-parleur du type panneau, le logement étanche à l'eau et le panneau étanche à l'eau transparent (4) étant raccordés de manière étanche l'un à l'autre.

2. Dispositif de navigation étanche à l'eau selon la revendication 1, dans lequel le panneau étanche à l'eau transparent (4) fonctionne comme un écran tactile.

3. Dispositif de navigation étanche à l'eau selon l'une quelconque des revendications précédentes, comprenant un premier joint qui est formé et disposé entre le logement étanche à l'eau (2) et le panneau étanche à l'eau transparent (4).

4. Dispositif de navigation étanche à l'eau selon l'une quelconque des revendications précédentes, comprenant au moins un bouton (8) qui est disposé de manière étanche à l'eau dans une ouverture du logement étanche à l'eau (2).

5. Dispositif de navigation étanche à l'eau selon la revendication 4, comprenant un deuxième joint qui est formé et disposé entre le logement étanche à l'eau (2) et le bouton étanche à l'eau (8) pour assurer l'étanchéité du dispositif de navigation.

6. Dispositif de navigation étanche à l'eau selon l'une quelconque des revendications précédentes, le logement étanche à l'eau (2) comprenant au moins un compartiment avec un couvercle de compartiment (10).

7. Dispositif de navigation étanche à l'eau selon la revendication 6, comprenant un troisième joint formé et disposé entre le logement étanche à l'eau (2) et/ou le couvercle de compartiment (10).
